# EUROPEAN PATENT APPLICATION

(11) **EP 4 472 072 A1**
(43) Date of publication of application: **04.12.2024**
(21) Application number: 22923214.5
(22) Date of filing: 25.07.2022
(51) Int. Cl.: H03F 3/68

(54) **RADIO FREQUENCY FRONT-END MODULE AND CORRESPONDING RADIO FREQUENCY FRONT-END SYSTEM, CHIP AND ELECTRONIC DEVICE**

(30) Priority: 28.01.2022 CN 202210108878; 03.03.2022 CN 202210203460
(71) Applicant: Vanchip (Tianjin) Technology Co. Ltd, Tianjin 300457 (CN)
(72) Inventor: LI, Hao, Tianjin 300457 (CN); BAI, Yunfang, Tianjin 300457 (CN)
(74) Representative: Wang, Bo
(86) International application number: PCT/CN2022/107712
(87) International publication number: WO 2023/142407

(57) **Abstract**

Disclosed in the present invention is a radio frequency front-end module, comprising at least one driving amplifier and at least one power amplifier. The output end of the driving amplifier is connected to the input end of the power amplifier. The radio frequency front-end module is powered by a power supply when working. When a preset power switching condition is met, the at least one driving amplifier and/or the power amplifier is powered by the power supply and a battery supply. The radio frequency front-end module provided by the present invention can eliminate the limitation of insufficient working current of a power management chip on the overall maximum output power in a low-voltage and high-power working state, and meets the application requirements of the electronic device on an APT mode.

## Description

### BACKGROUND

### Technical Field

The present invention relates to a radio frequency front-end module, also relates to a multimode-multiband radio frequency front-end system, an integrated circuit chip, and an electronic device that include the radio frequency front-end module, and relates to the field of radio frequency integrated circuit technologies.

### Related Art

With the development of communication technologies and the continuous increase of data services, an electronic device represented by a communication terminal has an increasingly higher requirement on the performance of a radio frequency front-end module. For example, the radio frequency front-end module is required to have more working modes and frequency bandwidths to satisfy communications standard requirements of different regions, while also implementing higher efficiency to maintain the long standby time of the electronic device.

To satisfy the foregoing requirements, a radio frequency front-end module using an envelope tracking (ET for short) mode or an average power tracking (APT for short) mode has gradually become a trend in the industry. The ET mode is a working mode that establishes a connection between a working voltage of a power amplifier and an input radio frequency signal to follow each other in real time, to improve working efficiency of the power amplifier. The APT mode is a working mode that automatically adjusts a working voltage of the power amplifier in combination with parameters of the power amplifier based on pre-output power of the power amplifier. In practice, when output power in the ET mode is lower than a preset value, the working efficiency may be lower than that in the APT mode. Therefore, the APT/ET mode is often used. In other words, the ET mode is used in a high power state, and the APT mode is used in a medium or a low power output state.

In addition, an existing radio frequency front-end module is usually powered using a high voltage in a high power condition. However, high voltage power supply may reduce working reliability of the radio frequency front-end module. In addition, a Boost DC-DC module needs to be used. This may significantly increase costs of the electronic device. In a case of low voltage power supply, although the radio frequency front-end module may be powered without the Boost DC-DC module, the working reliability is improved. However, a working current needed for the low voltage power supply is much larger than that for the high voltage power supply. An existing power management chip generally cannot provide a large enough working current, resulting in a difficulty for the radio frequency front-end module to implement a high power state in the case of the low voltage power supply.

### SUMMARY

A primary technical problem to be resolved in the present invention is to provide a radio frequency front-end module with an improved a power supply mode. The radio frequency front-end module can eliminate limitation of overall maximum output power caused by an insufficient working current of a power management chip under a working status of a low voltage and high power.

Another technical problem to be resolved in the present invention is to provide a radio frequency front-end system including the foregoing radio frequency front-end module.

Another technical problem to be resolved in the present invention is to provide an integrated circuit chip and a corresponding electronic device that include the foregoing radio frequency front-end module.

To achieve the above objectives, the following technical solutions are used in the present invention:
According to a first aspect of an embodiment of the present invention, a radio frequency front-end module is provided, including at least one driver amplifier and at least one power amplifier. An output end of the driver amplifier is connected to an input end of the power amplifier.

The radio frequency front-end module is powered by a power supply when working. When a preset power switching condition is satisfied, the at least one driver amplifier and/or power amplifier are/is powered by both the power supply and a battery supply.

Preferably, the power switching condition is that a maximum working current of the radio frequency front-end module reaches or exceeds a maximum current provided by a single power management chip.

Alternatively, the power switching condition is that output power of the radio frequency front-end module reaches or exceeds maximum linear power of the power supply supplying power independently.

Preferably, when a quantity of the driver amplifiers is greater than one, the driver amplifiers are cascaded with each other to form a driving amplification circuit.

Preferably, when a quantity of the power amplifiers is greater than one, the power amplifiers are connected in parallel to form a power amplification circuit.

Preferably, an output end of the power amplifier is connected to an impedance matching network. The impedance matching network includes a switch, a capacitor, and an inductor. The switch opens and closes based on a working status of the power amplifier to change output impedance of the impedance matching network.

Preferably, the driver amplifier and the power amplifier both have an independently controlled power supply network.

Preferably, an over current protect circuit and an over voltage protect circuit are connected in series on each power supply network.

Preferably, the power supply network includes a first bypass capacitor, a second bypass capacitor, a sixth bypass capacitor, and a first switch. One end of the first bypass capacitor is grounded. The other end of the first bypass capacitor is connected to the battery supply. One end of the second bypass capacitor is grounded. The other end of the second bypass capacitor is connected to a common end of the first switch. One end of the sixth bypass capacitor is grounded. The other end of the sixth bypass capacitor is connected to the power supply. The other end of the first switch is switched between two power options, and one of the power options is the battery supply and the other is the power supply.

Alternatively, the power supply network includes a first bypass capacitor, a second bypass capacitor, and a second switch. One end of the second bypass capacitor is connected to one end of the second switch. The other end of the second bypass capacitor is grounded directly. The other end of the second switch is connected to the battery supply, and is connected to one end of the first bypass capacitor. The other end of the first bypass capacitor is directly grounded.

Alternatively, the power supply network includes a third bypass capacitor, a fourth bypass capacitor, and a third switch. One end of the third bypass capacitor is connected to the power supply. The other end of the third bypass capacitor is grounded. One end of the fourth bypass capacitor is connected to the power supply. The other end of the fourth bypass capacitor is grounded after being connected to the third switch.

Preferably, a power divider is provided on the input end of the power amplifier, and a power combiner is provided on an output end of the power amplifier.

The power divider is any one of a 90-degree power divider, a Wilkinson power divider, a transformer power divider, or a 180-degree power divider.

The power combiner is any one of a 90-degree power combiner, a Wilkinson power combiner, a transformer power combiner, or a 180-degree power combiner.

Alternatively, the power divider is replaced by a coupler.

According to a second aspect of an embodiment of the present invention, a multimode-multiband radio frequency front-end system is provided, including a battery supply, a power management chip, and N radio frequency front-end modules connected in parallel. The battery supply supplies power to the power management chip. The power management chip provides a corresponding power supply. The battery supply and the power supply separately supply power to each radio frequency front-end module. N is a positive integer.

According to a third aspect of an embodiment of the present invention, an integrated circuit chip is provided, including the foregoing radio frequency front-end module.

According to a fourth aspect of an embodiment of the present invention, an electronic device is provided, including the foregoing radio frequency front-end module.

Compared with the conventional technologies, the radio frequency front-end module provided in the present invention can eliminate limitation of overall maximum output power caused by an insufficient working current of a power management chip under a working status of a low voltage and high power, and satisfy an application requirement of an electronic device for an APT (that is, average power tracking) mode. The technical improvement solution with a clear principle and a simple structure provided in the present invention may be applied to various radio frequency front-end modules.

### BRIEF DESCRIPTION OF THE DRAWINGS

FIG. 1 is a schematic diagram of a typical radio frequency front-end module in the conventional technologies;
FIG. 2 is a schematic diagram of a circuit of a radio frequency front-end module according to Embodiment 1 of the present invention;
FIG. 3 is a schematic diagram of a circuit of a radio frequency front-end module according to Embodiment 2 of the present invention;
FIG. 4 is a sketch of a structure of a multimode-multiband radio frequency front-end system using a radio frequency front-end module according to the present invention;
FIG. 5 is a schematic diagram of a power architecture of a multimode-multiband radio frequency front-end system using a radio frequency front-end module according to the present invention;
FIG. 6 is a schematic diagram of a circuit of a radio frequency front-end module according to Embodiment 3 of the present invention;
FIG. 7 is a schematic diagram of a breakdown structure of three corresponding power supply networks (PSN) according to Embodiment 3 of the present invention;
FIG. 8 is a schematic diagram of a circuit of a radio frequency front-end module according to Embodiment 4 of the present invention;
FIG. 9 is a schematic diagram of a breakdown structure of three corresponding power supply networks (PSN) according to Embodiment 4 of the present invention;
FIG. 10 is a schematic diagram of a circuit of a radio frequency front-end module according to Embodiment 5 of the present invention;
FIG. 11 is a schematic diagram of a breakdown structure of three corresponding power supply networks (PSN) according to Embodiment 5 of the present invention;
FIG. 12 is a schematic diagram of a circuit of a radio frequency front-end module according to Embodiment 6 of the present invention;
FIG. 13 is a schematic diagram of a breakdown structure of three corresponding power supply networks (PSN) according to Embodiment 6 of the present invention;

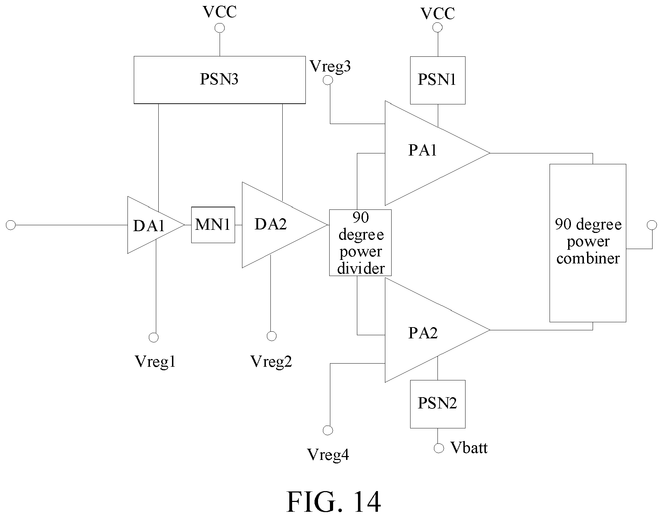

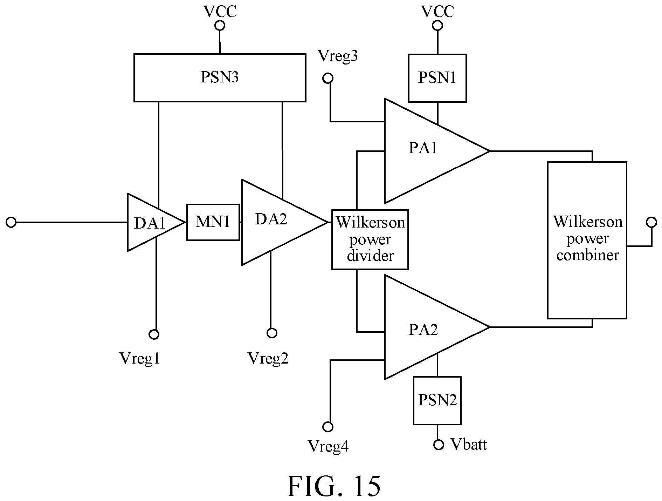

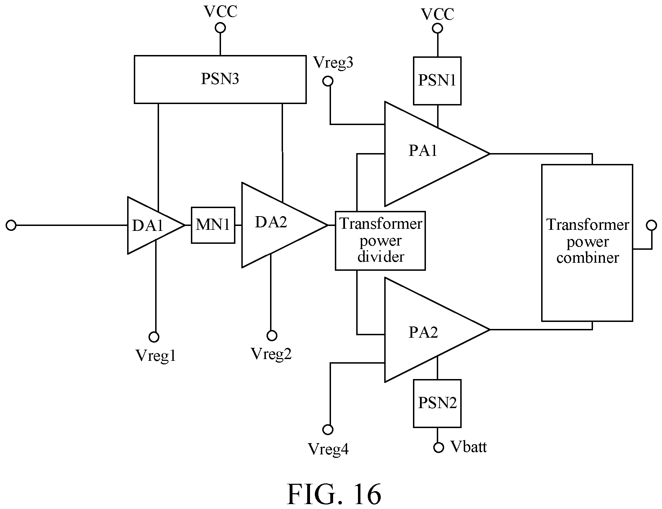

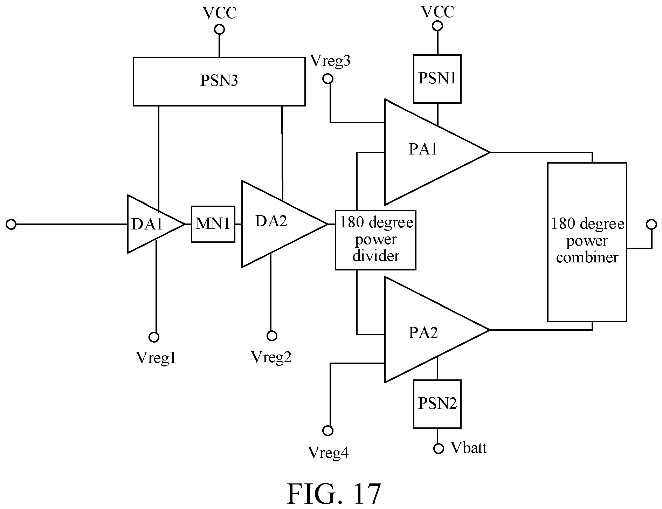

FIG. 14 to FIG. 17 are different deformation examples according to Embodiment 7 of the present invention respectively, where in FIG. 14, input power is divided into two parts by a 90 degree power divider, and output power is combined by a 90 degree power combiner; in FIG. 15, input power is divided into two parts by a Wilkinson power divider, and output power is combined by a Wilkinson power combiner; in FIG. 16, input power is divided into two parts by a transformer power divider, and output power is combined by a transformer power combiner; in FIG. 17, input power is divided into two parts by a 180 degree power divider, and output power is combined by a 180 degree power combiner;
FIG. 18 is a schematic diagram of a circuit of a radio frequency front-end module according to Embodiment 8 of the present invention;
FIG. 19 is a schematic diagram of a circuit of a radio frequency front-end module according to Embodiment 9 of the present invention;
FIG. 20 is a schematic diagram of a circuit of a radio frequency front-end module according to Embodiment 10 of the present invention; and
FIG. 21 is an example diagram of an electronic device using a radio frequency front-end module.

### DETAILED DESCRIPTION

The technical content of the present invention is described in detail and specifically with reference to the accompanying drawings and specific embodiments below.

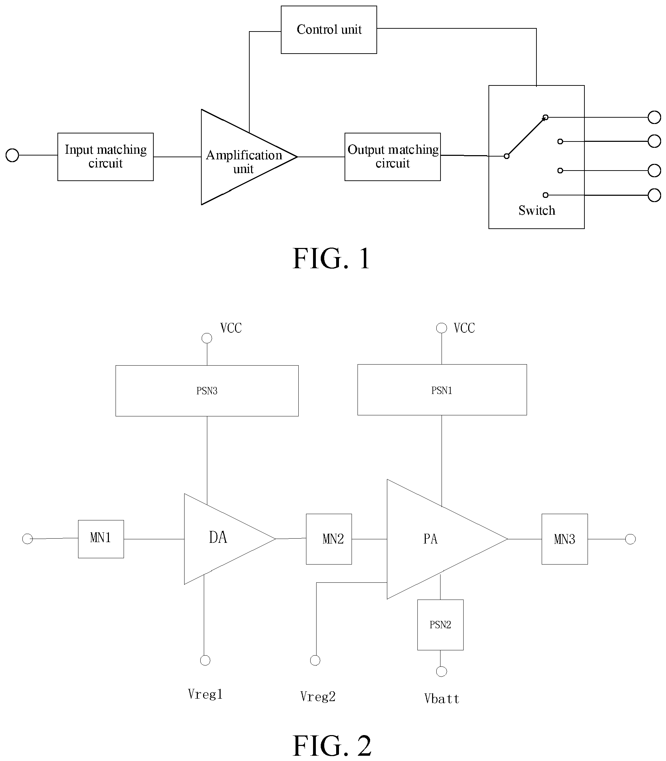

As shown in FIG. 1, a typical radio frequency front-end module in the conventional technologies includes an input matching circuit, an amplification unit, an output matching circuit, a control unit, and a switch. The input matching circuit is connected to an input end, and connected to the amplification unit, to implement impedance matching between the amplification unit and a pre-stage circuit. The amplification unit is connected between the input matching circuit and the output matching circuit, in use of implementing power amplification of an input small signal. The output matching circuit is connected to the amplification unit, and connected to one circuit of a gating switch, in use of implementing power matching of the amplification unit. The control unit is connected between the gating switch and a bias power supply end of the amplification unit, in use of providing a bias voltage and a logic level needed for the amplification unit and the gating switch to work. The gating switch controls, based on the logic level, an amplified radio frequency signal to select different ports for output.

In an existing radio frequency front-end module, the amplification unit often includes at least one driver amplifier (DA for short) and at least one power amplifier (PA for short). Both the driver amplifier and the power amplifier may be powered by a battery supply Vbatt. Alternatively, the driver amplifier may be powered by a battery supply Vbatt and the power amplifier may be powered by a power supply VCC. However, in a medium or a low power output state, the existing radio frequency front-end module needs to have a specific amplifier that needs to be powered by the battery supply Vbatt. However, the battery supply Vbatt has a fixed voltage and does not have an average power tracking function, so that implemented work efficiency is low, and an APT mode cannot be entered. Therefore, requirements of modern communication technology for high-efficiency applications cannot be satisfied.

To resolve the foregoing problem, an embodiment of the present invention first provides a radio frequency front-end module with an improved a power supply mode. A core idea of the radio frequency front-end module is that during normal working, the amplification unit is powered by the single power supply VCC to ensure that the radio frequency front-end module can implement the APT (that is, average power tracking) mode. When a preset power switching condition is satisfied, the amplification unit is powered by both the power supply VCC and the battery supply Vbatt, to ensure that the radio frequency front-end module can implement a working status of high power in a case of low voltage power supply.

Various implementations of the radio frequency front-end module are described in detail below with reference to different embodiments shown in FIG. 2 to FIG. 20.

In Embodiment 1 of the present invention, the radio frequency front-end module includes at least one stage driving amplification circuit and at least one stage power amplification circuit. The driving amplification circuit and the power amplification circuit are cascaded together to form an amplification unit. The driving amplification circuit includes at least one driver amplifier (if there is more than one driver amplifier, a plurality of driver amplifiers are cascaded). A main function of the driver amplifier is to provide a gain and driving power to the power amplification circuit. The power amplification circuit includes at least one power amplifier (if there is more than one power amplifier, a plurality of power amplifiers are connected in parallel). Impedance matching networks may be configured between adjacent stage driver amplifiers and between the driving amplification circuit and the power amplification circuit. Meanwhile, corresponding impedance matching networks may also be configured between an input end and the driving amplification circuit and between the power amplification circuit and an output end, and are used as an input matching circuit and an output matching circuit, respectively.

In Embodiment 1 shown in FIG. 2, the driving amplification circuit includes one driver amplifier DA and the power amplification circuit includes one power amplifier PA. A first impedance matching network (MN for short) MN1 is configured between an input end of the radio frequency front-end module and the driver amplifier DA. A second impedance matching network MN2 is configured between the driver amplifier DA and the power amplifier PA. A third impedance matching network MN3 is configured between the power amplifier PA and an output end of the radio frequency front-end module. A power supply VCC supplies power to the power amplifier PA through a first power supply network PSN1 and supplies power to the driver amplifier DA through a third power supply network PSN3. When a preset power switching condition is satisfied, a battery supply Vbatt supplies power to the power amplifier PA through a second power supply network PSN2. In addition, the driver amplifier DA has an independently configured first bias voltage Vreg1, and the power amplifier PA has an independently set second bias voltage Vreg2. The power supply VCC is provided by a power management chip and is used for providing a working voltage and a working current to a corresponding driver amplifier (DA) and power amplifier (PA). The driver amplifier (DA) is responsible for providing a gain and input power needed by the power amplifier (PA). The power amplifier (PA) is responsible for providing output power. Each impedance matching network (such as MN1, MN2, and MN3 in FIG. 2) may include passive devices such as a switch, a capacitor, an inductor, a coupler (coupler), and a transformer (transformer). Details are not described herein.

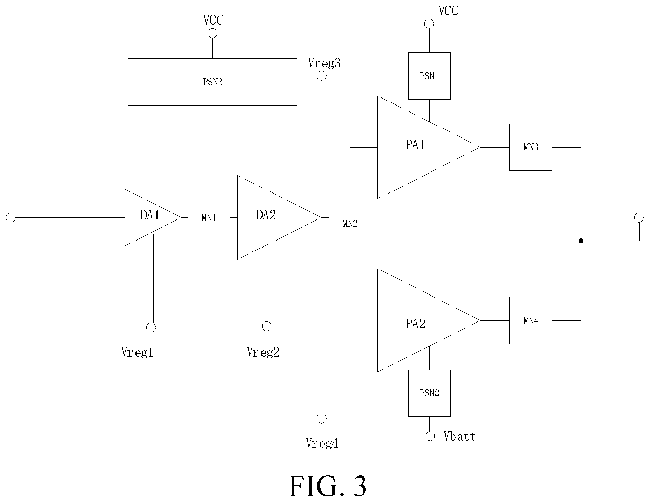

In Embodiment 2 shown in FIG. 3, a driving amplification circuit is implemented by a first driver amplifier DA1 and a second driver amplifier DA2 that are cascaded. A first impedance matching network MN1 is configured between the first driver amplifier DA1 and the second driver amplifier DA2 to be used as a stage matching network. An input end of the first driver amplifier DA1 is connected to an input end of a radio frequency front-end module. A power amplification circuit is implemented by two power amplifiers PA1 and PA2 that are connected in parallel. An output end of the second driver amplifier DA2 is connected to a second impedance matching network MN2. The second impedance matching network MN2 is separately connected to input ends of the two power amplifiers PA1 and PA2 that are connected in parallel, to be used as an impedance matching network and a power distribution network. An output end of the first power amplifier PA1 is connected to one end of a third impedance matching network MN3. An output end of the second power amplifier PA2 is connected to one end of a fourth impedance matching network MN4. The other end of the third impedance matching network MN3 is connected to the other end of the fourth impedance matching network MN4 in parallel to be jointly connected to an output end of the radio frequency front-end module. The third impedance matching network MN3 and the fourth impedance matching network MN4 whose output ends are connected may include passive devices such as a switch, a capacitor, an inductor, a coupler, and a transformer, and are used as an output matching network and a power combining network that are used for matching output impedance to optimal load impedance of the power amplifier. Other impedance matching networks such as the first impedance matching network MN1 and the second impedance matching network MN2 may also include passive devices such as a capacitor, an inductor, a coupler, and a transformer.

In different embodiments of the present invention, each driving amplification circuit and each power amplification circuit has an independently controlled power supply network. The power supply networks may include a bypass capacitor, an inductor, and a switch. By using the power supply networks, power ends of each driving amplification circuit and power amplification circuit may implement switching between a power supply VCC (provided by a power management chip), a battery supply Vbatt, and high impedance (that is, in a disconnected state from a power supply) under different output power requirements, to implement different power output states. For example, in Embodiment 2 shown in FIG. 3, the power supply VCC is separately connected to the first driver amplifier DA1 and the second driver amplifier DA2 through a third power supply network PSN3. The first driver amplifier DA1 and the second driver amplifier DA2 have an independently configured first bias voltage Vreg1 and an independently set second bias voltage Vreg2, respectively. Similarly, the first power amplifier PA1 has an independently set third bias voltage Vreg3, and the second power amplifier PA2 has an independently configured fourth bias voltage Vreg4. The power supply VCC supplies power to the first power amplifier PA1 through a first power supply network PSN1. Meanwhile, when a preset power switching condition is satisfied, the battery supply Vbatt supplies power to the second power amplifier PA2 through a second power supply network PSN2. The foregoing four bias voltages Vreg1, Vreg2, Vreg3, and Vreg4 provide bias voltages to the corresponding driver amplifiers (DA) and power amplifiers (PA), respectively.

When the radio frequency front-end module is working normally, and if the radio frequency front-end module is in a medium or a low power output state, it may be selected that some power amplifiers work and remaining power amplifiers are turned off. For example, in Embodiment 2 shown in FIG. 3, the second power amplifier PA2 may be turned off by adjusting the fourth bias voltage Vreg4 used as a bias voltage, so that only a pre-stage driving amplification circuit and the first power amplifier PA1 are working normally in an amplification unit. In this case, only the power supply VCC needs to supply power, and an entire working current of an entire amplification circuit is provided by the power supply VCC. Because a voltage and a current output by the power supply VCC may be adjusted flexibly, the radio frequency front-end module may implement a working status of high power in a case of low voltage power supply by control of the power supply VCC.

When the radio frequency front-end module is working normally, and if the radio frequency front-end module is in a high power output state, the first power amplifier PA1 and the second power amplifier PA2 may work simultaneously. In this case, if a power supply end of a specific power amplifier is connected to the power supply VCC provided by the power management chip, a maximum current of the power amplifier does not exceed a maximum working current of the power management chip. Because a maximum working current provided by a single power management chip is limited, maximum output power of the radio frequency front-end module is often limited by a maximum working current of the power supply VCC, which is difficult to satisfy an actual need. Therefore, in the present invention, a power supply mode of the radio frequency front-end module is improved. When a preset power switching conditions is satisfied, the amplification unit is no longer only powered by the power supply VCC as a single power supply, but is jointly powered by the power supply VCC and the battery supply Vbatt. The power switching condition herein includes, but is not limited to the following: 1. A maximum working current of the radio frequency front-end module reaches or exceeds a maximum current that a single power management chip can provide; or 2. Output power of the radio frequency front-end module reaches or exceeds maximum linear power of the power supply VCC supplying power independently. The maximum linear power refers to maximum power that can be output by the radio frequency front-end module when an adjacent channel leakage ratio (adjacent channel leakage ratio, ACLR) and an error vector magnitude (error vector magnitude, EVM) satisfy requirements of the 3GPP specification. Specific values of the ACLR and the EVM may be measured by using a spectrum analyzer or a mobile phone integrated tester. When the foregoing power switching condition is satisfied, the battery supply Vbatt (in this case, the battery supply Vbatt is equivalent to a supplementary power supply) is added to power supply work of the driver amplifier and/or power amplifier. In other words, the battery supply is connected to power supply ends of at least one power amplifier and/or driver amplifier, so that the problem that the maximum output power of the radio frequency front-end module is limited by the maximum working current of the power supply VCC can be resolved.

In addition, output matching networks of the radio frequency front-end module (such as the third impedance matching network MN3 and the fourth impedance matching network MN4 in FIG. 3) has the following features: When a supply voltage of a specific power amplifier changes, a working status of the power amplifier is affected, for example, from an amplifying state to an OFF state, or from an OFF state to an amplifying state. In this case, output impedance of the impedance matching networks may be adjusted by controlling a switch in the impedance matching network, such as one impedance value when the switch is closed and another impedance value when the switch is opened. Related passive devices in the impedance matching network are combined flexibly, and impedance of an output end may be adjusted, so that compensate for an impedance change caused by a change in a working status of the amplification unit.

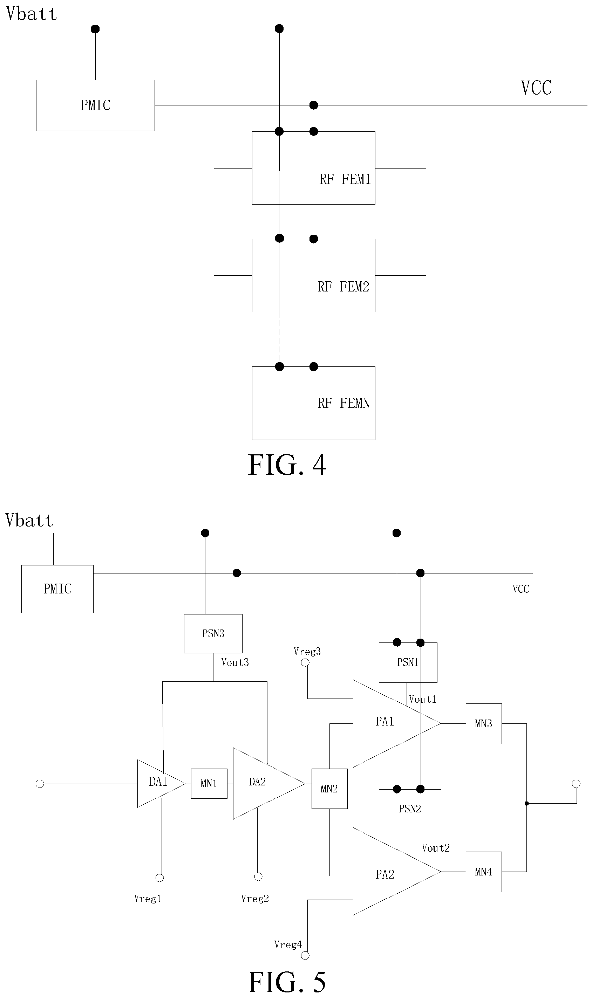

FIG. 4 is a sketch of a structure of a multimode-multiband radio frequency front-end system using the radio frequency front-end module. In an embodiment shown in FIG. 4, the multimode-multiband radio frequency front-end system includes a battery supply Vbatt, a power management chip, and N radio frequency front-end modules (RF FEM1, RF FEM2, ..., and RF FEMN) connected in parallel. N is a positive integer. Each radio frequency front-end module uses the basic architecture in Embodiment 1. At an application side (which is usually an electronic device such as a smartphone) of the radio frequency front-end module, the battery supply Vbatt supplies power to the power management IC (PMIC for short), and the power management chip provides a corresponding power supply VCC. The battery supply Vbatt and the power supply VCC separately supply power to each radio frequency front-end module.

FIG. 5 is a schematic diagram of a power architecture of a multimode-multiband radio frequency front-end system using the radio frequency front-end module. In an embodiment shown in FIG. 5, a battery supply Vbatt and a power supply VCC output Vout1 to a first power amplifier PA1 to power through a first power supply network PSN1. The battery supply Vbatt and the power supply VCC output Vout2 to a second power amplifier PA2 to power through a second power supply network PSN2. The battery supply Vbatt and the power supply VCC output Vout3 to a first driver amplifier DA1 and a second driver amplifier DA2 to power through a third power supply network PSN3. If there are N radio frequency front-end modules connected in parallel, the same procedure is repeated.

The radio frequency front-end module and the corresponding multimode-multiband radio frequency front-end system provided in the present invention may have a variety of power output states, to satisfy requirements of different communication modes. In one embodiment of the present invention, output states of the radio frequency front-end module and the corresponding multimode-multiband radio frequency front-end system may be divided into three power segments: a high-power mode (HPM for short), a middle power mode (MPM for short), and a low power mode (LPM for short). Specific power division of the foregoing three segments is related to chip design, and value setting is flexible. For example, the value may be 18 dBm to 26 dBm (the high power mode), 8 dBm to 18 dBm (the medium power mode), and less than 8 dBm (the low power mode), may be 16 dBm to 28 dBm (the high power mode), 6 dBm to 16 dBm (the medium power mode), and less than 6 dBm (the low power mode), or may be 18 dBm to 30 dBm (the high power mode), 6 dBm to 18 dBm (the medium power mode), and less than 6 dBm (the low power mode). In another embodiment of the present invention, the foregoing output states may be further subdivided into six, eight, or even more power segments, which are not listed one by one herein.

In addition, the radio frequency front-end module and the corresponding multimode-multiband radio frequency front-end system provided in the present invention may work in different frequency bands. The frequency bands include, but are not limited to, a low frequency band (LB for short) being roughly in 600 MHz to 900 MHz, a middle frequency band (MB for short) being roughly in 1800 MHz to 2200 MHz, and a high frequency band being roughly in 2300 MHz to 2700 MHz, which are not listed one by one herein.

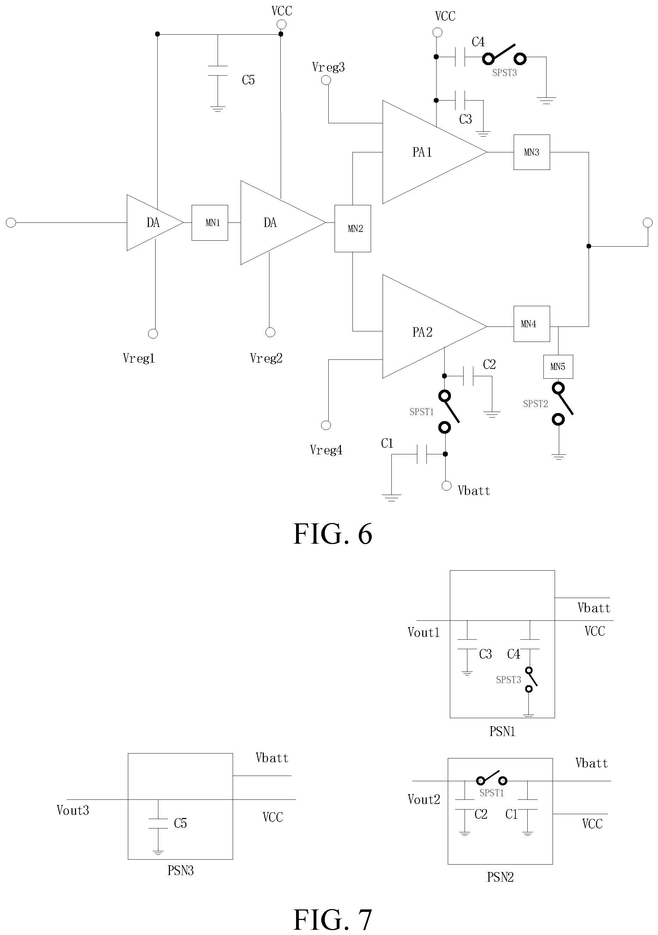

Several other embodiments of the present invention are further described below with reference to FIG. 6 to FIG. 20.

In Embodiment 3 shown in FIG. 6, a basic architecture of the radio frequency front-end module is basically the same as that of Embodiment 2 shown in FIG. 3. Details are not described herein. FIG. 7 is a schematic diagram of a breakdown structure of three corresponding power supply networks (PSN) according to Embodiment 3 shown in FIG. 6. In Embodiment 3, a first power supply network PSN1 supplying power to a first power amplifier PA1 includes two bypass (bypass) capacitors C3 and C4 and a switch SPST3. One end of the bypass capacitor C3 is connected to a power supply VCC. The other end of the bypass capacitor C3 is grounded directly. One end of the bypass capacitor C4 is connected to the power supply VCC. The other end of the bypass capacitor C4 is grounded after being connected to the switch SPST3. Similarly, a second power supply network PSN2 supplying power to a second power amplifier PA2 includes two bypass capacitors C1 and C2 and a switch SPST1. One end of the bypass capacitor C2 is connected to a common end of the switch SPST1. The other end of the bypass capacitor C2 is grounded directly. The other end of the switch SPST1 is connected to a battery supply Vbatt and is connected to one end of the bypass capacitor C1. The other end of the bypass capacitor C1 is grounded directly.

Optionally, a fifth impedance matching network MN5 is provided on an output end of the second power amplifier PA2. The fifth impedance matching network MN5 is grounded via a switch SPST2 connected in series. The fifth impedance matching network MN5 used as an output impedance regulating network of the second power amplifier PA2, may include passive devices such as a capacitor, an inductor, and a resistor.

In Embodiment 3, when an amplification unit in the radio frequency front-end module is in a multi-power supply mode, the switch SPST1 is in an ON state and provides power supply to the second power amplifier PA2; the switch SPST3 is also in an ON state, and the bypass capacitor C4 is connected to the circuit; and at the same time, the switch SPST2 is opened, and the fifth impedance matching network MN5 is not connected to the circuit. When the amplification unit in the radio frequency front-end module is in a single power supply mode, the switch SPST1 is opened and the switch SPST2 is closed, so that the fifth impedance matching network MN5 is connected to the circuit to compensate for an impedance change caused by the second power amplifier PA2 not working. When the amplification unit in the radio frequency front-end module does not work, the switch SPST3 is opened, the bypass capacitor C4 is not connected to the circuit, and the SPST1 is opened and is in a high impedance state. It may be learned that the bypass capacitor C4 and the switch SPST3 are also optional circuit design.

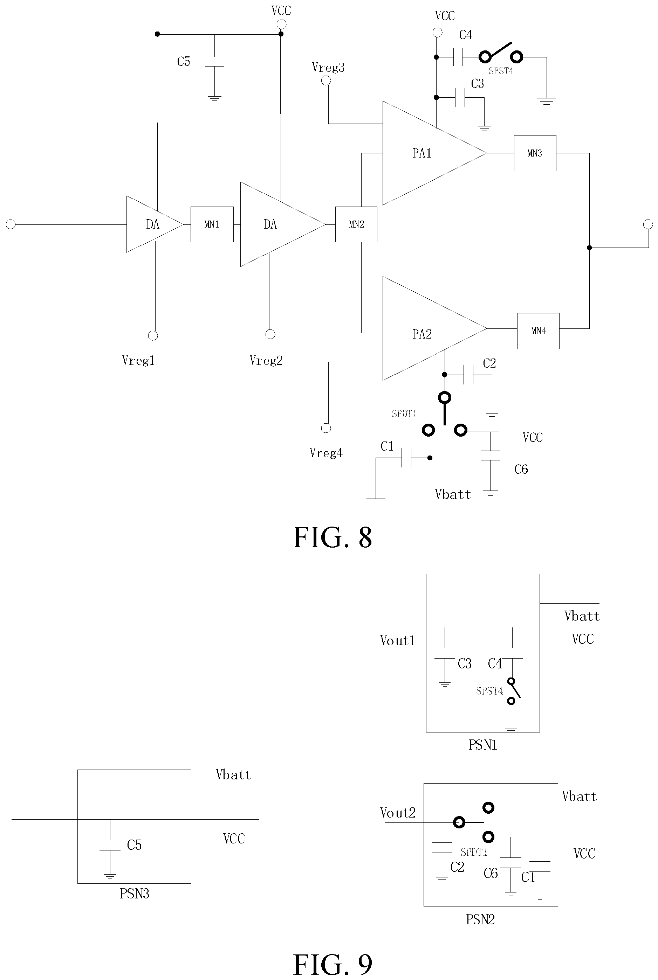

In Embodiment 4 shown in FIG. 8, a basic architecture of the radio frequency front-end module is basically the same as that of Embodiment 2 shown in FIG. 3. Details are not described herein. FIG. 9 is a schematic diagram of a breakdown structure of three corresponding power supply networks (PSN) according to Embodiment 4 shown in FIG. 8. In Embodiment 4, a first power supply network PSN1 supplying power to a first power amplifier PA1 includes two bypass capacitors C3 and C4 and a switch SPST4. One end of the bypass capacitor C3 is connected to a power supply VCC. The other end of the bypass capacitor C3 is grounded directly. One end of the bypass capacitor C4 is connected to the power supply VCC. The other end of the bypass capacitor C4 is grounded after being connected to the switch SPST4. It may be learned that circuit design of this part is the same as the corresponding part in Embodiment 3. Circuit design of Embodiment 4 that is different from Embodiment 3 is mainly reflected in the second power supply network PSN2 supplying powering to the second power amplifier PA2. In Embodiment 4, the second power supply network PSN2 includes three bypass capacitors C1, C2, and C6 and a single-pole double-throw switch SPDT1. One end of the bypass capacitor C1 is grounded. The other end of the bypass capacitor C1 is connected to a battery supply Vbatt. One end of the bypass capacitor C2 is grounded. The other end of the bypass capacitor C2 is connected to a common end of the single-pole double-throw switch SPDT1. One end of the bypass capacitor C6 is grounded. The other end of the bypass capacitor C6 is connected to a power supply VCC. The other end of the single-pole double-throw switch SPDT1 switches between two power options. One of the power options is the battery supply Vbatt and the other is the power supply VCC.

In Embodiment 4, when an amplification unit in the radio frequency front-end module is in a multi-power supply mode, the single-pole double-throw switch SPDT1 selects the battery supply Vbatt to be on. When the amplification unit in the radio frequency front-end module is in a single power supply mode, the single-pole double-throw switch SPDT1 selects the power supply VCC to be on, so that the amplification unit is in an APT mode. In addition, when the amplification unit in the radio frequency front-end module works, the switch SPST4 is on. When the amplification unit in the radio frequency front-end module does not work, the switch SPST4 is opened, and the single-pole double-throw switch SPDT1 is opened and is in a high impedance state.

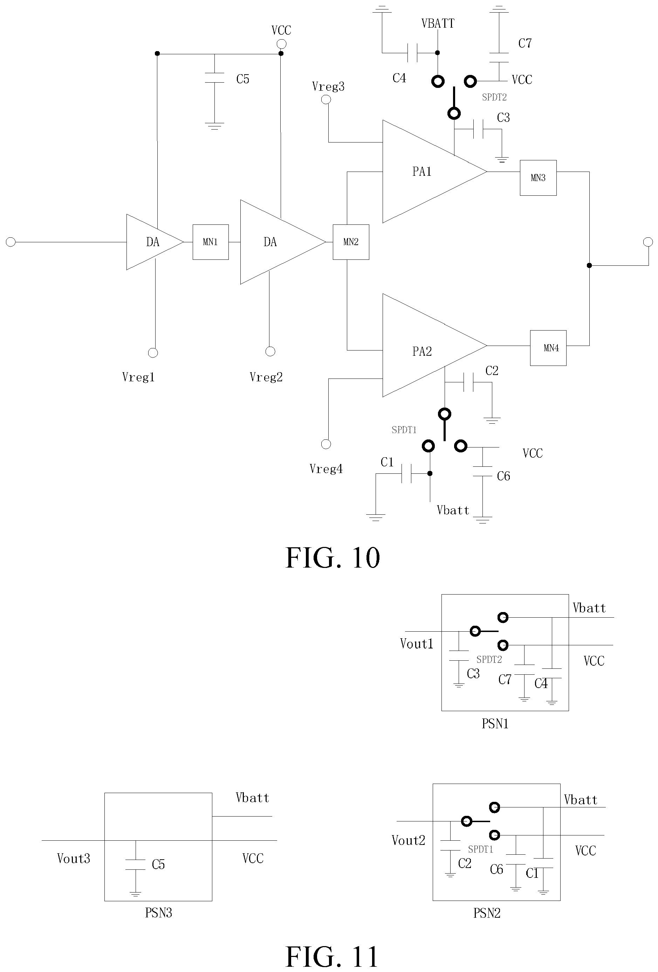

In Embodiment 5 shown in FIG. 10, a basic architecture of the radio frequency front-end module is basically the same as that of Embodiment 2 shown in FIG. 3. Details are not described herein. FIG. 11 is a schematic diagram of a breakdown structure of three corresponding power supply networks (PSN) according to Embodiment 5 shown in FIG. 10. In Embodiment 5, a first power supply network PSN1 supplying power to a first power amplifier PA1 and a second power supply network PSN2 supplying power to a second power amplifier PA2 both use the circuit design of the second power supply network PSN2 in Embodiment 3. In other words, the first power supply network PSN1 includes three bypass capacitors C3, C4, and C7 and a single-pole double-throw switch SPDT2. One end of the bypass capacitor C4 is grounded. The other end of the bypass capacitor C4 is connected to a battery supply Vbatt. One end of the bypass capacitor C3 is grounded. The other end of the bypass capacitor C3 is connected to a common end of the single-pole double-throw switch SPDT2. One end of the bypass capacitor C7 is grounded. The other end of the bypass capacitor C7 is connected to a power supply VCC. The other end of the single-pole double-throw switch SPDT2 switches between two power options. One of the power options is the battery supply Vbatt and the other is the power supply VCC. The second power supply network PSN2 includes three bypass capacitors C1, C2, and C6 and a single-pole double-throw switch SPDT1. One end of the bypass capacitor C1 is grounded. The other end of the bypass capacitor C1 is connected to a battery supply Vbatt. One end of the bypass capacitor C2 is grounded. The other end of the bypass capacitor C2 is connected to a common end of the single-pole double-throw switch SPDT1. One end of the bypass capacitor C6 is grounded. The other end of the bypass capacitor C6 is connected to a power supply VCC. The other end of the single-pole double-throw switch SPDT1 switches between two power options. One of the power options is the battery supply Vbatt and the other is the power supply VCC.

In Embodiment 5, when an amplification unit in the radio frequency front-end module is in a multi-power supply mode, the single-pole double-throw switches SPDT1 and SPDT2 both select the battery supply Vbatt to be on. When the amplification unit in the radio frequency front-end module is in a single power supply mode, the single-pole double-throw switches SPDT1 and SPDT2 both select the power supply VCC to be on, so that the amplification unit is in an APT mode. When the amplification unit in the radio frequency front-end module is off, the single-pole double-throw switches SPDT1 and SPDT2 are both opened and are in a high impedance state.

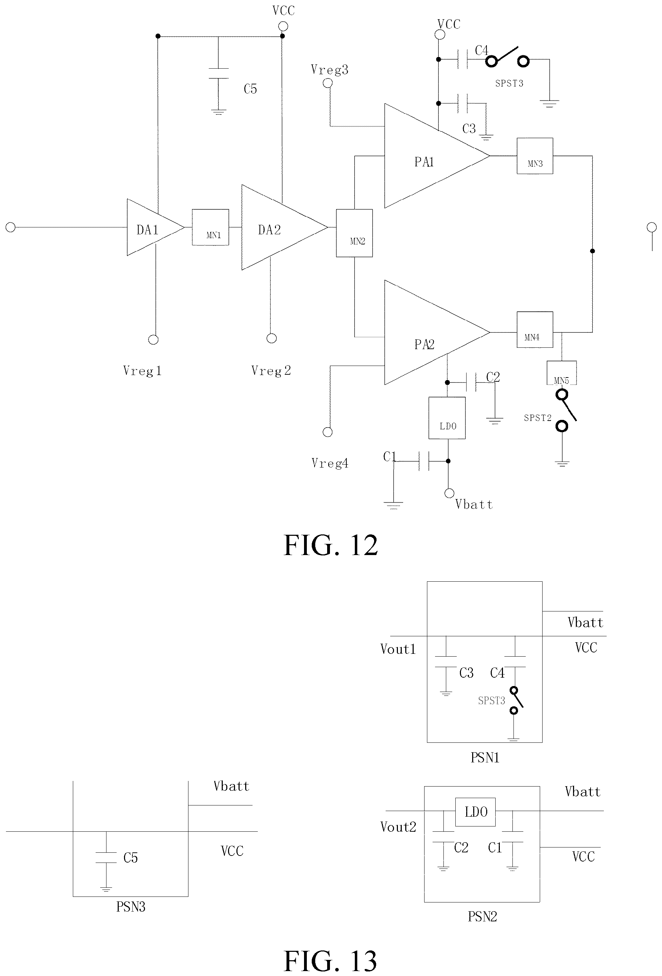

In Embodiment 6 shown in FIG. 12, a basic architecture of the radio frequency front-end module is basically the same as that of Embodiment 2 shown in FIG. 3. Details are not described herein. FIG. 13 is a schematic diagram of a breakdown structure of three corresponding power supply networks (PSN) according to Embodiment 6 shown in FIG. 12. In Embodiment 6, a first power supply network PSN1 supplying power to a first power amplifier PA1 includes two bypass (bypass) capacitors C3 and C4 and a switch SPST3. One end of the bypass capacitor C3 is connected to a power supply VCC. The other end of the bypass capacitor C3 is grounded directly. One end of the bypass capacitor C4 is connected to the power supply VCC. The other end of the bypass capacitor C4 is grounded after being connected to the switch SPST3. Similarly, a second power supply network PSN2 supplying power to a second power amplifier PA2 includes two bypass capacitors C1 and C2 and an LDO circuit. One end of the bypass capacitor C2 is connected to the LDO circuit. The other end of the bypass capacitor C2 is grounded directly. The other end of the LDO circuit is connected to a battery supply Vbatt and is connected to one end of the bypass capacitor C1. The other end of the bypass capacitor C1 is grounded directly. In Embodiment 6, the LDO circuit is powered by the battery supply Vbatt. Output Vout2 of the battery supply Vbatt is a stable voltage value. When an output voltage of the battery supply Vbatt fluctuates greatly, the voltage value of Vout2 is stable, to provide over voltage protect for the second power amplifier PA2. Optionally, a fifth impedance matching network MN5 is provided on an output end of the second power amplifier PA2. The fifth impedance matching network MN5 is grounded via a switch SPST2 connected in series. The fifth impedance matching network MN5 used as an output impedance regulating network of the second power amplifier PA2, may include passive devices such as a capacitor, an inductor, and a resistor.

In Embodiment 6, when an amplification unit in the radio frequency front-end module is in a multi-power supply mode, the LDO circuit is in an ON state and provides power supply to the second power amplifier PA2; the switch SPST3 is also in an ON state, and the bypass capacitor C4 is connected to the circuit; and at the same time, the switch SPST2 is opened, and the fifth impedance matching network MN5 is not connected to the circuit. When the amplification unit in the radio frequency front-end module is in a single power supply mode, the LDO circuit is opened and the switch SPST2 is closed, so that the fifth impedance matching network MN5 is connected to the circuit to compensate for an impedance change caused by the second power amplifier PA2 not working. When the amplification unit in the radio frequency front-end module does not work, the switch SPST3 is opened, the bypass capacitor C4 is not connected to the circuit, and the SPST1 is opened and is in a high impedance state. It may be learned that the bypass capacitor C4 and the switch SPST3 are also optional circuit design.

In Embodiment 7 of the present invention, different power combining structures used by the radio frequency front-end module are disclosed. In Embodiment 7, a basic architecture of the radio frequency front-end module is basically the same as that of Embodiment 2 shown in FIG. 3. Details are not described herein. FIG. 14 to FIG. 17 are different deformation examples of Embodiment 7 separately. In FIG. 14, input power is divided into two parts by a 90-degree power divider (power divider), and output power is combined by a 90-degree power combiner. In FIG. 15, input power is divided into two parts by a Wilkinson power divider, and output power is combined by a Wilkinson power combiner. In FIG. 16, input power is divided into two parts by a transformer power divider, and output power is combined by a transformer power combiner. In FIG. 17, input power is divided into two parts by a 180-degree power divider, and output power is combined by a 180-degree power combiner. In Embodiment 7, an output power regulation range of the radio frequency front-end module may be expanded by a flexible combination of a power divider and a power combiner, satisfying actual needs of different frequencies and different communication modes. In addition, power supply networks (PSN) in FIG. 14 to FIG. 17 may be the power supply network solutions mentioned in the foregoing embodiments and different combinations thereof. Details are not described herein.

It should be noted that the power divider used in Embodiment 7 may be replaced by a coupler (coupler). The coupler may divide input power unevenly into two parts, which are separated according to different ratios, such as 1:2 or 1:3, to implement a wider range and more flexible output power regulation.

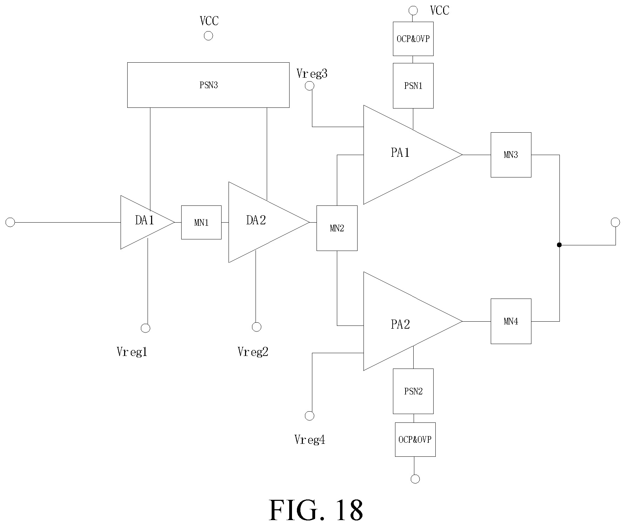

FIG. 18 shows Embodiment 8 of the present invention. In Embodiment 8, a basic architecture of the radio frequency front-end module is basically the same as that of Embodiment 2 shown in FIG. 3. Details are not described herein. A main difference between Embodiment 8 and Embodiment 2 is that an over current protect (OCP for short) circuit and an over voltage protect (OVP for short) circuit are connected in series on a first power supply network PSN1 and/or a second power supply network PSN2. Therefore, working reliability of an amplification unit is improved. When a current of the amplification unit exceeds a specific threshold, the OCP circuit carries out overcurrent protection to limit a maximum current. When a power supply voltage of the amplification unit exceeds a threshold, the OVP circuit carries out overvoltage protection to limit a maximum voltage.

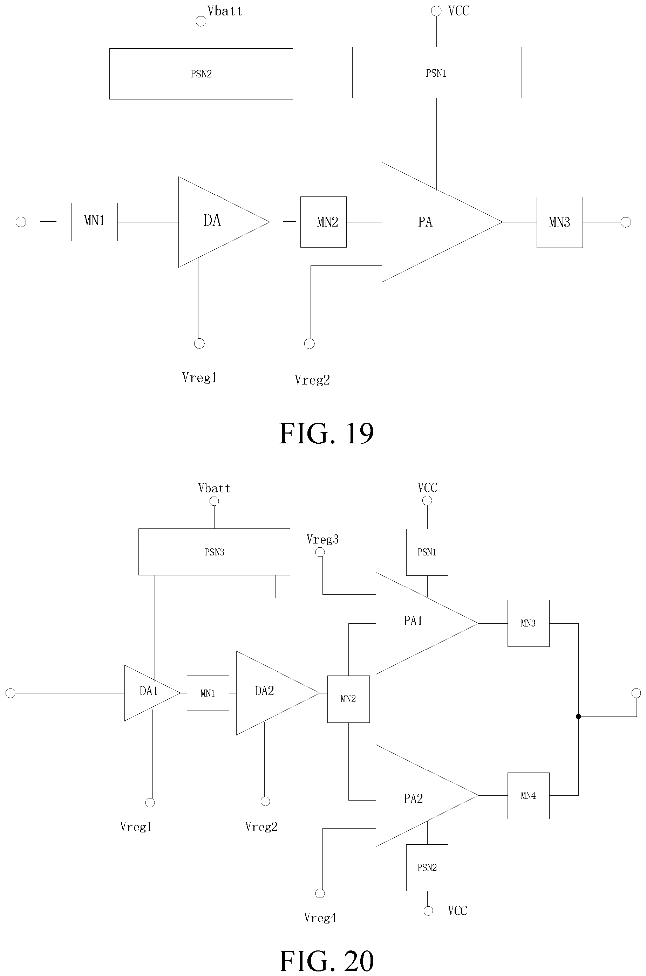

FIG. 19 shows Embodiment 9 of the present invention. In Embodiment 9, a basic architecture of the radio frequency front-end module is basically the same as that of Embodiment 1 shown in FIG. 2. Details are not described herein. A main difference between Embodiment 9 and Embodiment 1 is that a battery supply Vbatt supplies power to a driver amplifier DA through a second power supply network PSN2, and a power supply VCC only supplies power to a power amplifier PA through a first power supply network PSN1. The adjustment of the power supply mode may implement a wider range and more flexible output power regulation, while simplify circuit design of the first power supply network PSN1 and/or the second power supply network PSN2.

FIG. 20 shows Embodiment 10 of the present invention. In Embodiment 10, a basic architecture of the radio frequency front-end module is basically the same as that of Embodiment 2 shown in FIG. 3. Details are not described herein. A main difference between Embodiment 10 and Embodiment 2 is that a battery supply Vbatt supplies power to driver amplifiers (such as DA1 and DA2) through a third power supply network PSN3, and a power supply VCC only supplies power to power amplifiers (such as PA1 and PA2). The adjustment of the power supply mode may implement a wider range and more flexible output power regulation, while simplify circuit design of each power supply network (PSN1 to PSN3).

It should be noted that the driving amplification circuit in each of the foregoing embodiments merely shows a one-stage or two-stage driver amplifier. This is not limited in the technical solutions of the present invention. In practice, the driving amplification circuit may be implemented by using a single-stage driver amplifier, or by using a three-stage, four-stage, or even multi-stage driver amplifier that cascades. Similarly, the power amplification circuit in each of the foregoing embodiments merely shows one or two power amplifiers. This is not limited in the technical solutions of the present invention. In practice, the power amplification circuit may be implemented by using a single power amplifier, or by using three, four, or even more power amplifiers that are connected in parallel.

In addition, the radio frequency front-end module provided in embodiments of the present invention may be used in an integrated circuit chip. Details of a specific structure of the radio frequency front-end module in the integrated circuit chip are not described herein.

The radio frequency front-end module may alternatively be used in an electronic device as an important part of a radio frequency integrated circuit. The electronic device mentioned here refers to a device that may be used in a mobile environment, supports a variety of communication standards such as GSM, EDGE, TD-SCDMA, TDD-LTE and FDD-LTE, and includes a mobile phone, a laptop, a tablet, an internet of vehicles terminal, and the like. In addition, the technical solutions provided in the present invention are also applicable to a scenario that another radio frequency integrated circuit is used in, such as a communication base station and an intelligent connected vehicle.

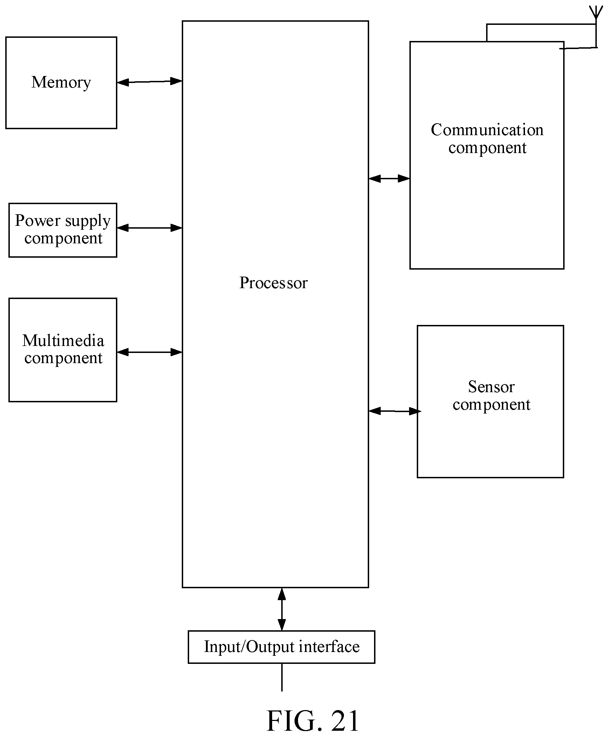

As shown in FIG. 21, the electronic device includes at least a processor and a memory, and may further include a communication component, a sensor component, a power supply component, a multimedia component, and an input/output interface according to actual needs. The memory, the communication component, the sensor component, the power supply component, the multimedia component, and the input/output interface are connected to the processor. The memory may be a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, or the like. The processor may be a central processing unit (CPU), a graphic processing unit (GPU), a field-programmable gate array (FPGA), an application-specific integrated circuit (ASIC), a digital signal processing (DSP) chip, or the like. Another communication component, sensor component, power supply component, multimedia component, and the like may be implemented by using a common component. Details are not described herein.

Compared with the conventional technologies, the radio frequency front-end module provided in the present invention can eliminate limitation of overall maximum output power caused by an insufficient working current of a power management chip under a working status of a low voltage and high power, and satisfy an application requirement of an electronic device for an APT (that is, average power tracking) mode. The technical improvement solution with a clear principle and a simple structure provided in the present invention may be applied to various radio frequency front-end modules.

The foregoing content provides a detailed description of the radio frequency front-end module and the corresponding radio frequency front-end system, chip, and electronic device provided in the present invention. For a person of ordinary skill in the art, any apparent modification made to the present invention without departing from the substantial content of the present invention constitutes an infringement of the patent rights of the present invention, and the person who makes such modification shall bear corresponding legal responsibilities.

## Claims

1. A radio frequency front-end module, comprising at least one driver amplifier and at least one power amplifier, wherein an output end of the driver amplifier is connected to an input end of the power amplifier; and
the radio frequency front-end module is powered by a power supply when working; and when a preset power switching condition is satisfied, the at least one driver amplifier and/or power amplifier are/is powered by both the power supply and a battery supply.

2. The radio frequency front-end module according to claim 1, wherein
the power switching condition is that a maximum working current of the radio frequency front-end module reaches or exceeds a maximum current provided by a single power management chip.

3. The radio frequency front-end module according to claim 1, wherein
the power switching condition is that output power of the radio frequency front-end module reaches or exceeds maximum linear power of the power supply supplying power independently.

4. The radio frequency front-end module according to any one of claims 1 to 3, wherein
when a quantity of the driver amplifiers is greater than one, the driver amplifiers are cascaded with each other.

5. The radio frequency front-end module according to any one of claims 1 to 3, wherein
when a quantity of the power amplifiers is greater than one, the power amplifiers are connected in parallel.

6. The radio frequency front-end module according to claim 1, wherein
an output end of the power amplifier is connected to an impedance matching network, the impedance matching network comprises a switch, a capacitor, and an inductor, and the switch opens and closes based on a working status of the power amplifier to change output impedance of the impedance matching network.

7. The radio frequency front-end module according to claim 1, wherein
the driver amplifier and the power amplifier both have an independently controlled power supply network.

8. The radio frequency front-end module according to claim 7, wherein
the power supply network comprises a first bypass capacitor, a second bypass capacitor, a sixth bypass capacitor, and a first switch; one end of the first bypass capacitor is grounded, the other end of the first bypass capacitor is connected to the battery supply; one end of the second bypass capacitor is grounded, the other end of the second bypass capacitor is connected to a common end of the first switch; one end of the sixth bypass capacitor is grounded, the other end of the sixth bypass capacitor is connected to the power supply; the other end of the first switch is switched between two power options, and one of the power options is the battery supply and the other is the power supply.

9. The radio frequency front-end module according to claim 7, wherein
the power supply network comprises a first bypass capacitor, a second bypass capacitor, and a second switch; one end of the second bypass capacitor is connected to one end of the second switch, the other end of the second bypass capacitor is grounded directly; the other end of the second switch is connected to the battery supply, and is connected to one end of the first bypass capacitor; and the other end of the first bypass capacitor is directly grounded.

10. The radio frequency front-end module according to claim 7, wherein
the power supply network comprises a third bypass capacitor, a fourth bypass capacitor, and a third switch; one end of the third bypass capacitor is connected to the power supply, the other end of the third bypass capacitor is grounded; one end of the fourth bypass capacitor is connected to the power supply, and the other end of the fourth bypass capacitor is grounded after being connected to the third switch.

11. The radio frequency front-end module according to any one of claims 8 to 10, wherein
the switch is replaced by an LDO circuit.

12. The radio frequency front-end module according to any one of claims 7 to 10, wherein
an over current protect circuit and an over voltage protect circuit are connected in series on the power supply network.

13. The radio frequency front-end module according to any one of claims 1 to 3, wherein
a power divider is provided on the input end of the power amplifier, and a power combiner is provided on an output end of the power amplifier, wherein
the power divider is any one of a 90-degree power divider, a Wilkinson power divider, a transformer power divider, or a 180-degree power divider; and
the power combiner is any one of a 90-degree power combiner, a Wilkinson power combiner, a transformer power combiner, or a 180-degree power combiner.

14. The radio frequency front-end module according to claim 13, wherein
the power divider is replaced by a coupler.

15. A multimode-multiband radio frequency front-end system, comprising a battery supply, a power management chip, and N radio frequency front-end modules according to any one of claims 1 to 14, wherein the radio frequency front-end modules are connected in parallel; and
the battery supply supplies power to the power management chip, the power management chip provides a corresponding power supply, the battery supply and the power supply separately supply power to each radio frequency front-end module, and N is a positive integer.

16. An integrated circuit chip, comprising the radio frequency front-end module according to any one of claims 1 to 14.

17. An electronic device, comprising the radio frequency front-end module according to any one of claims 1 to 14.
